(19) **Europäisches Patentamt**

**European Patent Office**

**Office européen des brevets**

(11) **EP 0 658 838 B1**

(12) **FASCICULE DE BREVET EUROPEEN**

(45) Date de publication et mention
de la délivrance du brevet:
**12.04.2000 Bulletin 2000/15**

(51) Int. Cl.⁷: **G06F 1/025**, H03K 23/66

(21) Numéro de dépôt: **94203540.3**

(22) Date de dépôt: **06.12.1994**

(54) **Dispositif de synthèse de fréquences**

Frequenzsynthetisierer

Frequency synthesizer

(84) Etats contractants désignés:
**DE FR GB IT**

(30) Priorité: **15.12.1993 FR 9315072**

(43) Date de publication de la demande:
**21.06.1995 Bulletin 1995/25**

(73) Titulaires:
- **TRT LUCENT TECHNOLOGIES**
  **75008 Paris (FR)**
  Etats contractants désignés:
  **FR**
- **LUCENT TECHNOLOGIES INC.**
  **Murray Hill, New Jersey 07974-0636 (US)**
  Etats contractants désignés:
  **DE GB IT**

(72) Inventeurs:
- **Albert, Patrick,**
  **Société Civile S.P.I.D.**
  **F-75008 Paris (FR)**
- **Vergnes, Alain,**
  **Société Civile S.P.I.D.**
  **F-75008 Paris (FR)**
- **Salle, Bertrand,**
  **Société Civile S.P.I.D.**
  **F-75008 Paris (FR)**

(74) Mandataire:
**Williams, David John et al**
**Lucent Technologies Inc.,**
**Intellectual Property Division,**
**5 Mornington Road**
**Woodford Green, Essex IG8 0TU (GB)**

(56) Documents cités:
**US-A- 4 031 476**

- **PROCEEDINGS OF THE 39TH ANNUAL
  FREQUENCY SYMPOSIUM 1985, 29-31 MAY
  1985, PHILADELPHIA, PA. , USA, 1985 IEEE,
  NEW YORK, USA., pages 189-192, C.
  RICHARDSON 'A NOVEL SYNTHESISER FOR
  MINIATURE SSB RADIO EQUIPMENT'**
- **EDN ELECTRICAL DESIGN NEWS, vol. 32,
  no.18, 3 Septembre 1987 NEWTON,
  MASSACHUSETTS US, pages 244-246, A.
  PARTYKA 'Frequency divider generates 50%
  duty cycle'**

**Description**

La présente invention concerne un dispositif de synthèse de fréquences, comportant un accès d'entrée pour un code numérique définissant la fréquence à synthétiser et un circuit accumulateur pour accumuler sous forme de nombres lesdits codes numériques successivement au rythme des signaux d'une horloge de cumul.

Un tel dispositif trouve d'importantes applications notamment dans la transmission de données où la fréquence de la porteuse de celles-ci doit être établie avec une très grande précision.

Un dispositif de ce genre est connu du brevet des Etats-Unis-d'Amérique N° 4 514 696.

Ce dispositif fournit une fréquence de sortie $f_u$ à partir d'un code numérique C codé sur N éléments binaires :

$$f_u = C \times \frac{F_R}{2^N}$$

où $F_R$ est la fréquence des signaux d'une horloge de référence constituée de préférence, selon les pratiques courantes, par un quartz.
De cette formule on déduit le pas de variation Δf donné par une formule :

$$\Delta f = \frac{F_R}{2^N}$$

en admettant que la variation de C est unitaire.

Dans les applications envisagées ci-dessus où le dispositif est utilisé dans une boucle d'asservissement de phase de façon à bien restituer la porteuse, ce pas de variation est jugé trop important.

Un autre dispositiv est connu du brevet US-A-4 031 476.

L'invention propose un dispositif selon les revendications 1 et 2.

La description suivante faite en regard des dessins ci-annexés, le tout donné à titre d'exemple non limitatif, fera bien comprendre comment l'invention peut être réalisée.

La figure 1 montre un dispositif de synthèse de fréquence conforme à l'invention.

La figure 2 montre une variante de réalisation d'un diviseur variable faisant partie d'un dispositif de l'invention.

La figure 3 est un diagramme temps destiné à l'explication du dispositif de la figure 2.

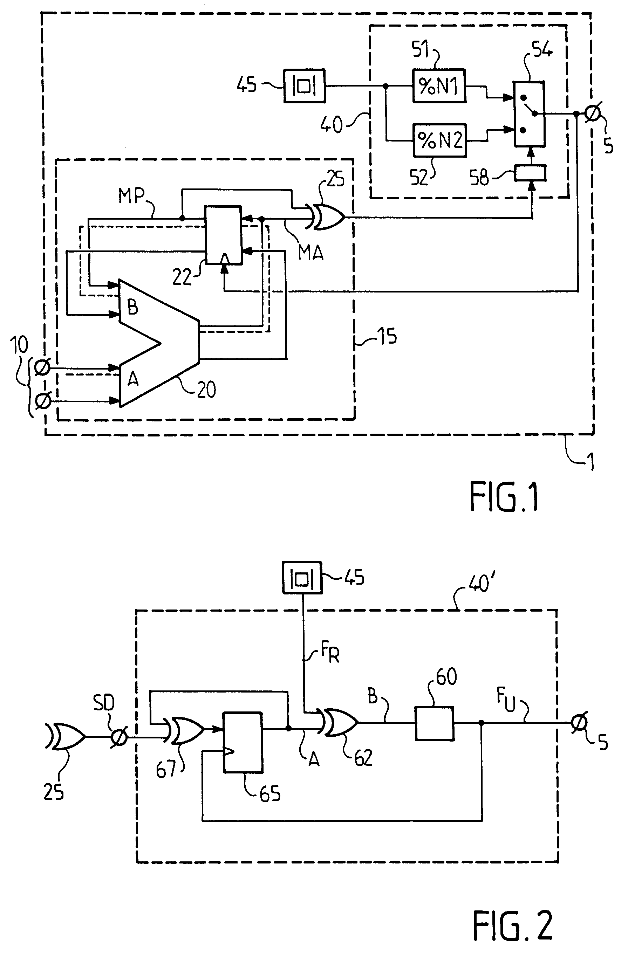

A la figure 1, la référence 1 indique un dispositif conforme à l'invention. Ce dispositif fournit à sa sortie 5 un signal dont la fréquence est déterminée par un code numérique de N éléments binaires par exemple, appliqué aux accès d'entrée 10. Ce dispositif comporte un circuit accumulateur 15 formé d'un additionneur 20 à deux entrées de code A et B et d'un registre d'accumulation 22. L'entrée A de l'additionneur reçoit le code numérique appliqué aux accès 10 et l'entrée B est reliée par l'intermédiaire du registre 22 à la sortie de l'additionneur 15. Une porte "OU-EXCLUSIF" 25 faisant office de décodeur d'accumulation fournit un signal logique "1" pour indiquer le changement de valeur de l'élément binaire de plus fort poids de l'accumulateur. Pour cela, les entrées de cette porte sont reliées respectivement au fil d'entrée MA et au fil de sortie MP du registre 22 transmettant les éléments binaires de plus fort poids.

Conformément à l'invention, un signal indiquant un certain contenu du circuit accumulateur, qui est par exemple fourni à la sortie de la porte OU-EXCLUSIF 25, est utilisé pour activer un circuit diviseur variable 40 comportant une entrée reliée à un oscillateur de référence 45 et une sortie qui constitue la sortie du dispositif 1. Le circuit 40 est formé de deux diviseurs fixes 51 et 52 pour diviser par $N_1$ et $N_2$ la fréquence de l'oscillateur 45. Un commutateur à deux positions 54 connecte à la sortie 5 le signal élaboré par l'un de ces diviseurs. Le choix de ces positions est déterminé par la valeur du signal de sortie de la porte 25. Les accumulations s'effectuent, selon un aspect de l'invention, au rythme du signal présent à la sortie 5 qui constitue un signal d'horloge de cumul.

Pour bien comprendre l'intérêt de l'invention, il convient de faire appel aux considérations suivantes. Soit M le nombre d'éléments binaires que traite le circuit accumulateur 15. Le code C à l'entrée 10 codé sur N éléments binaires est tel que :

$$0 \le C \le 2^N - 1$$

Ce code s'accumule dans le registre et provoque le changement de valeur de l'élément binaire de plus fort poids en k accumulations quand :

$$k.C \ge 2^{M-1}$$

Si on appelle $T_u$ la période du signal à la sortie 5, l'intervalle de temps $T_{SD}$ qui sépare deux impulsions à "1" est donné par la relation :

$$T_{SD} = \frac{2^{(M-1)}}{C} \times T_U$$

Si on admet que lorsque SD = 0 on a :

$$F_{U1} = \frac{F_R}{N1} \; ; \; T_{U1} = \frac{1}{F_{U1}} = \frac{N1}{F_R}$$

et si SD = 1 :

$$F_{U2} = \frac{F_R}{N2} \ , \ T_{U2} = \frac{1}{F_{U2}} = \frac{N2}{F_R}$$

on tire une relation entre la fréquence utilisateur $F_U$ et le code C :
Pendant $T_{SD} - T_{U2}$, SD vaut "0" et la fréquence utilisateur

$$F_{U1} = F_R/N1$$

Pendant $T_{U2}$, SD vaut "1" et la fréquence utilisateur $F_{U2} = F_R/N2$ La fréquence utilisateur moyenne vaut :

$$F_U = \frac{1}{T_{SD}} \times \left( ((T_{SD} - T_{U2}) \times \frac{F_R}{N1}) + T_{U2} \times \frac{F_R}{N2} \right)$$

soit finalement :

$$F_U = F_R \times \frac{2^{(M-1)}}{C \times (N2-N1) + 2^{(M-1)} \times N1}$$

On s'aperçoit donc que le pas de variation $\Delta f$ est devenu :

$$\Delta f = \frac{F_R \cdot 2^{M-1} \cdot (N_1 - N_2)}{[C(N_2 - N_1) + 2^{M-1} \cdot N_1]^2}$$

et en choisissant N1 et N2 on maîtrise ce pas d'une manière aussi fine que l'on veut.

La figure 2 montre un exemple de réalisation d'un circuit à division variable 40' où N1 = 16 et N2 = 15,5 donc bien adapté à des réglages de phase. Ce circuit est formé d'un diviseur 60 qui divise par $N_3$ ($N_3$ = 16) la fréquence des signaux de l'oscillateur à quartz 45 transmis par l'intermédiaire d'une porte OU-EXCLUSIF 62 à deux entrées dont la première est donc reliée à la sortie de l'oscillateur 45 et la deuxième à la sortie d'une bascule de type D portant la référence 65. La sortie de cette bascule est en outre reliée à une entrée d'une autre porte OU-EXCLUSIF 67 dont une autre entrée constitue l'entrée de ce circuit 40' et est donc connectée à la sortie de la porte 25. La sortie de la porte OU-EXCLUSIF 67 est reliée à l'entrée de la bascule 65. L'entrée qui autorise le changement d'état de cette bascule est reliée à la sortie du diviseur 60.

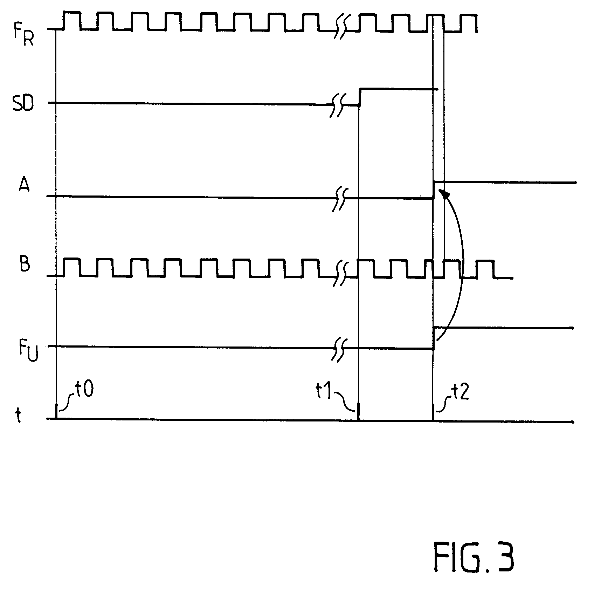

le fonctionnement de ce circuit 40' est expliqué à l'aide de la figure 3. Pour cette explication on fera intervenir des signaux $F_R$, $F_U$, SD, A et B qui se présentent respectivement aux sorties de l'oscillateur 45, du diviseur 60, de la bascule 65 et de la porte 62.

On se place à l'instant $t_0$ et on admet que le signal SD a la valeur "0" ainsi que le signal A. De ce fait le signal B est une copie du signal $F_R$. On se place ensuite à l'instant $t_1$ où le signal SD prend la valeur "1", le signal à la sortie de la porte 67 s'inverse alors, à l'entrée de la bascule 65 qui est préparée à changer d'état. Ceci arrive à $t_2$ lorsque le diviseur 60 a fini son cycle de comptage. A cause de ce basculement les signaux B représentent maintenant les signaux $F_R$ inversés. On notera que cette inversion ne coïncide jamais avec un front des signaux $F_R$, ceci étant dû au retard apporté par les différents circuits. On a ainsi créé une demi-impulsion supplémentaire à diviser par le diviseur 60. Si le signal SD garde sa valeur "1", la fin du cycle de division de ce même diviseur 60 provoquera le basculement de la bascule 65 et de là la création d'une demi-impulsion pour le diviseur 60.

**Revendications**

1. Dispositif de synthèse de fréquences, comportant un accès d'entrée (10) pour un code numérique définissant la fréquence à synthétiser et un circuit accumulateur (15) pour accumuler sous forme de nombres lesdits codes numériques successivement au rythme des signaux d'une horloge de cumul,
   caractérisé en ce qu'il comporte une porte logique du type OU-EXCLUSIF (25) qui, couplé audit circuit accumulateur fournit une information indiquant le changement de la valeur de l'élément binaire de plus fort poids du nombre accumulé dans ledit circuit accumulateur et un circuit diviseur variable (40) piloté par cette information pour fournir à partir des signaux d'une horloge de référence les signaux de fréquence synthétisée, ledit circuit diviseur variable (40) étant formé de deux circuits diviseurs fixes (51,52) et d'un commutateur (54) pour sélectionner l'un ou l'autre des dits circuits diviseurs fixes en fonction de la fonction de l'information fournie par ladite porte logique (15).

2. Dispositif de synthèse de fréquences, comportant un accès d'entrée (10) pour un code numérique définissant la fréquence à synthétiser et un circuit accumulateur (15) pour accumuler sous forme de nombres lesdits codes numériques successivement au rythme des signaux d'une horloge de cumul,
   caractérisé en ce qu'il comporte une porte logique du type OU-EXCLUSIF (25) qui, couplé audit circuit accumulateur fournit une information indiquant le changement de la valeur de l'élément binaire de plus fort poids du nombre accumulé dans ledit circuit accumulateur et un circuit diviseur variable (40) piloté par cette information pour fournir à partir des signaux d'une horloge de référence les signaux de fréquence synthétisée, le circuit diviseur variable (40') étant formé d'un circuit diviseur fixe (60) et de moyens d'inversion (62,65,67) pour inverser les signaux de l'horloge de référence.

**3.** Dispositif de synthèse de fréquences selon la revendication 1 ou 2, caractérisé en ce que les signaux de l'horloge de cumul sont constitués à partir des signaux de fréquence synthétisée.

**4.** Dispositif de synthèse de fréquences selon les revendications 1 à 3, caractérisé en ce que le circuit accumulateur (25) est formé d'un circuit d'addition (20) muni de deux entrées d'opérande (A,B) dont une est reliées audit accès d'entrée et l'autre, aux sorties d'un registre de cumul du circuit accumulateur.

**Claims**

**1.** Frequency synthesis device comprising an input port (10) for a digital code defining the frequency to be synthesized and an accumulator circuit (15) for accumulating in the form of numbers the said digital codes successively in tempo with the signals of an accumulating clock, characterized in that it comprises a logic gate of the EXCLUSIVE-OR type (25), which, coupled with the said accumulator circuit, provides a cue indicating the changing of the value of the highest order binary element of the number accumulated in the said accumulator circuit and a variable divider circuit (40) driven by this cue so as to provide, on the basis of the signals of a reference clock, the signals of synthesized frequency, the said variable divider circuit (40) being formed of two fixed divider circuits (51, 52) and of a switch (54) for selecting one or other of the said fixed divider circuits as a function of the function of the cue supplied by the said logic gate (15).

**2.** Frequency synthesis device comprising an input port (10) for a digital code defining the frequency to be synthesized and an accumulator circuit (15) for accumulating in the form of numbers the said digital codes successively in tempo with the signals of an accumulating clock, characterized in that it comprises a logic gate of the EXCLUSIVE-OR type (25), which, coupled with the said accumulator circuit, provides a cue indicating the changing of the value of the highest order binary element of the number accumulated in the said accumulator circuit and a variable divider circuit (40) driven by this cue so as to provide, on the basis of the signals of a reference clock, the signals of synthesized frequency, the variable divider circuit (40') being formed of a fixed divider circuit (60) and of means of inversion (62, 65, 67) for inverting the signals of the reference clock.

**3.** Frequency synthesis device according to Claim 1 or 2, characterized in that the signals of the accumulating clock are constructed on the basis of the signals of synthesized frequency.

**4.** Frequency synthesis device according to Claims 1 to 3, characterized in that the accumulator circuit (25) is formed of an addition circuit (20) furnished with two operand inputs (A, B), of which one is linked to the said input port and the other to the outputs of an accumulating register of the accumulator circuit.

**Patentansprüche**

**1.** Vorrichtung zur Frequenzsynthese mit einem Eingabeeingang (10) für einen die zu synthetisierende Frequenz definierenden digitalen Code und einer Akkumulatorschaltung (15) zum Akkumulieren der digitalen Codes in Zahlenform nacheinander im Takt der Signale eines Akkumulationstaktgebers, dadurch gekennzeichnet, daß sie ein logisches Gatter der EXKLUSIV-ODER Art (25), das, an die Akkumulatorschaltung angeschlossen, eine Information bereitstellt, die die Änderung des Wertes des höchstwertigen Bit-Elements der in dieser Akkumulatorschaltung akkumulierten Zahl anzeigt, und eine variable Teilerschaltung (40) aufweist, die durch diese Information gesteuert wird, um aus den Signalen eines Referenztaktgebers die Signale mit der synthetisierten Frequenz zu erzeugen, wobei die variable Teilerschaltung (40) aus zwei festen Teilerschaltungen (51, 52) und einem Schalter (54) zur Auswahl der einen oder der anderen der festen Teilerschaltungen in Abhängigkeit von der Funktion der durch das logisch Gatter (15) bereitgestellten Information gebildet wird.

**2.** Vorrichtung zur Frequenzsynthese mit einem Eingabeeingang (10) für einen die zu synthetisierende Frequenz definierenden digitalen Code und einer Akkumulatorschaltung (15) zum Akkumulieren der digitalen Codes in Zahlenform nacheinander im Takt der Signale eines Akkumulationstaktgebers, dadurch gekennzeichnet, daß sie ein logisches Gatter der EXKLUSIV-ODER Art (25), das, an die Akkumulatorschaltung angeschlossen, eine Information bereitstellt, die die Änderung des Wertes des höchstwertigen Bit-Elements der in dieser Akkumulatorschaltung akkumulierten Zahl anzeigt, und eine variable Teilerschaltung (40) aufweist, die durch diese Information gesteuert wird, um aus den Signalen eines Referenztaktgebers die Signale mit der synthetisierten Frequenz zu erzeugen, wobei die variable Teilerschaltung (40') von einer festen Teilerschaltung (60) und Invertiermitteln (62, 65, 67) zum Invertieren der Signale des Referenztaktgebers gebildet wird.

**3.** Vorrichtung zur Frequenzsynthese nach Anspruch 1 oder 2, dadurch gekennzeichnet, daß die Signale des Akkumulationstaktgebers aus Signalen mit der synthetisierten Frequenz gebildet werden.

4. Vorrichtung zur Frequenzsynthese nach den Ansprüchen 1 bis 3, dadurch gekennzeichnet, daß die Akkumulatorschaltung (25) aus einer Addierschaltung (20) gebildet wird, die mit zwei Operandeneingängen (A, B) versehen ist, von denen einer mit dem Eingabeeingang und der andere mit den Ausgängen eines Akkumulationsregisters der Akkumulatorschaltung verbunden ist.

FIG.1

FIG.2

FIG.3